# EUROPÄISCHE PATENTSCHRIFT

(11) **EP 2 345 074 B1**
(45) Veröffentlichungstag und Bekanntmachung des Hinweises auf die Patenterteilung: **24.08.2016**
(21) Anmeldenummer: 09771481.0
(22) Anmeldetag: 22.10.2009
(51) Int. Cl.: H01L 33/48, H01L 23/495, H01L 31/0203, H01L 23/31, H01L 23/00, H01L 33/62, H01L 33/52

(54) **TRÄGERKÖRPER FÜR EIN HALBLEITERBAUELEMENT, HALBLEITERBAUELEMENT UND VERFAHREN ZUR HERSTELLUNG EINES TRÄGERKÖRPERS**
SUPPORTING BODY FOR A SEMICONDUCTOR ELEMENT, SEMICONDUCTOR ELEMENT AND METHOD FOR PRODUCTION OF A SUPPORTING BODY
CORPS DE SUPPORT POUR UN COMPOSANT SEMI-CONDUCTEUR, COMPOSANT SEMI-CONDUCTEUR ET PROCÉDÉ DE FABRICATION D' UN CORPS DE SUPPORT

(30) Priorität: 28.10.2008 DE 102008053489
(43) Veröffentlichungstag der Anmeldung: 20.07.2011
(73) Patentinhaber: OSRAM Opto Semiconductors GmbH, 93055 Regensburg (DE)
(72) Erfinder: ZITZLSPERGER, Michael, 93047 Regensburg (DE); MÜTZEL, Stefanie, 80637 München (DE)
(74) Vertreter: Epping - Hermann - Fischer
(86) Internationale Anmeldenummer: PCT/DE2009/001484
(87) Internationale Veröffentlichungsnummer: WO 2010/048926

(56) Entgegenhaltungen:
- WO-A1-02/09180
- WO-A2-2004/004017
- US-A1- 2005 121 756
- US-A1- 2006 175 689
- US-A1- 2006 266 546
- US-A1- 2007 126 020
- US-A1- 2008 067 649
- US-B1- 7 410 830

## Beschreibung

Diese Patentanmeldung beansprucht die Priorität der deutschen Patentanmeldung 10 2008 053 489. 7.

Die vorliegende Anmeldung betrifft einen Trägerkörper, der für ein Halbleiterbauelement geeignet ist, sowie ein Verfahren zur Herstellung eines Trägerkörpers. Weiterhin wird ein Halbleiterbauelement mit einem Trägerkörper angegeben.

Für die Herstellung von Halbleiterbauelementen werden häufig so genannte Leadframes verwendet. Ein anderes Wort für Leadframe ist beispielsweise Leiterrahmen. Ein Leadframe weist elektrische Anschlussleiter für ein elektronisches Bauelement wie beispielsweise ein Halbleiterbauelement auf.

Die elektrischen Anschlussleiter sind beispielsweise mittels eines Rahmens des Leadframes in diesem verbunden und gehalten. Ein Leadframe besteht häufig zumindest im Wesentlichen aus gestanztem Kupferblech. Allgemein könnte man ein Leadframe als Metallplatte bezeichnen, in der mittels Aussparungen elektrische Anschlussleiter ausgebildet sind.

Bei der Herstellung von bekannten Halbleiterbauelementen wird häufig ein Leadframe mit einem Grundgehäuse aus Kunststoff umformt. Das Grundgehäuse bildet einen Trägerkörper für den Halbleiterchip. Das Grundgehäuse weist mindestens einen ersten und einen zweiten elektrischen Anschlussleiter auf, die durch das Leadframe gebildet sind. Der auf oder in dem Grundgehäuse montierte Chip wird zum Beispiel nachfolgend mit einer Kapselmasse umkapselt. Die elektrischen Anschlussleiter ragen zum Beispiel seitlich an einander entgegengesetzten Seiten aus dem Kunststoffteil des Grundgehäuses heraus.

Solches Bauelemente sind z.B. in der Patentschrift US 7410830 B1 und Patentanmeldungen WO 02/09180 A1, US 2005/0121756 A1 und US2008/0067649 A1 offenbart.

Es ist eine Aufgabe, einen Trägerkörper für ein Halbleiterbauelement anzugeben, der vielseitiger einsetzbar ist und/oder technisch einfacher herstellbar ist als herkömmliche Trägerkörper. Zudem soll ein besonders vorteilhaftes Halbleiterbauelement mit dem Trägerkörper sowie ein Verfahren zur Herstellung des Trägerkörpers oder des Halbleiterbauelements angegeben werden.

Es wird ein Trägerkörper für ein Halbleiterbauelement, insbesondere für ein optoelektronisches Halbleiterbauelement, angegeben. Der Trägerkörper ist insbesondere geeignet, mindestens einen Halbleiterkörper des Bauelements zu tragen. Er ist insbesondere als Bestandteil eines Gehäuses des Halbleiterbauelements vorgesehen.

Der Trägerkörper, gemäß dem anhängigen Anspruch 1, weist eine elektrisch leitfähige Leiterschicht und eine Verbindungsschicht auf, die über einander zugewandten Hauptflächen miteinander verbunden sind.

Sowohl die Verbindungsschicht als auch die Leiterschicht weisen mindestens einen gedünnten Bereich auf, in dem ihre Schichtdicke geringer als ihre maximale Schichtdicke ist. Die Verbindungsschicht ist in dem Fall, dass sie vollständig elektrisch leitfähig ist, zumindest gegenüber Teilen der Leiterschicht elektrisch isoliert.

Gemäß einer anderen Ausführungsform ist die Verbindungsschicht zumindest in Teilen elektrisch isolierend. Das heißt, ein Teil der Verbindungsschicht ist elektrisch leitfähig oder die gesamte Verbindungsschicht ist elektrisch isolierend.

Sowohl der Trägerkörper als auch die Leiterschicht und die Verbindungsschicht für sich sind selbsttragende oder freitragende Elemente, das heißt sie sind insbesondere in einem Zustand, in dem sie frei von weiterem Material sind, formstabil und können unter Beibehaltung ihrer Form als solche bewegt und transportiert werden.

Beschichtungen wie beispielsweise dünne Metallbeschichtungen, Kunststoffbeschichtungen oder dünne Schichten transparenter, elektrisch leitfähiger Oxide, die auf Materialflächen aufgebracht sind, fallen als solche nicht unter den Ausdruck "Verbindungsschicht" oder "Leiterschicht". Das gilt insbesondere, wenn die Beschichtung in einer Form, in der sie nicht auf einem anderen Material aufgebracht, sondern frei von weiterem Material ist, für eine übliche Verarbeitung aufgrund mangelnder Formstabilität nicht geeignet wäre. Derartige Beschichtungen können jedoch Teil der Verbindungsschicht und/oder Teil der Leiterschicht sein, solange die Verbindungsschicht und die Leiterschicht jeweils für sich freitragend oder selbsttragende Elemente sind. Gemäß einer zweckmäßigen Ausführungsform weisen sowohl die Verbindungsschicht als auch die Leiterschicht eine maximale Dicke von mindestens 50 µm, bevorzugt von mindestens 80 µm oder mindestens 90 µm auf. Das heißt, die Leiterschicht und/oder die Verbindungsschicht muss an mindestens einer Stelle eine Dicke aufweisen, die mindestens so groß wie eine der angegebenen Dicken ist, wobei die Dicke senkrecht zu einer Haupterstreckungsebene der Leiterschicht gemessen wird. Leiterschicht und Verbindungsschicht können unterschiedliche Dicken aufweisen.

Gemäß mindestens einer Ausführungsform ist die Verbindungsschicht, die Leiterschicht oder sowohl die Verbindungsschicht als auch die Leiterschicht eine Metallplatte oder weist eine Metallplatte auf.

Die Leiterschicht und Verbindungsschicht weisen jeweils eine flache Form mit einander gegenüberliegenden Hauptflächen auf, die durch Seitenflächen miteinander verbunden sind. Die Seitenflächen sind jeweils kleiner als die Hauptflächen. Durch die Maßnahme, den Trägerkörper zumindest mit zwei Teilen in Form einer Verbindungsschicht und einer Leiterschicht auszubilden die mit einem gedünnten Bereich versehen sind, kann der Trägerkörper mit Eigenschaften ausgebildet werden, die über herkömmliche Eigenschaften, wie der Eignung als Träger für einen Halbleiterchip und das bloße Aufweisen eines elektrischen Anschlussleiters, hinausgehen.

Der Ausdruck "gedünnter Bereich" impliziert kein bestimmtes Herstellungsverfahren für die Ausbildung derartiger Bereiche.

Es kann zwar zweckmäßig sein, ausgehend von einer Leiterschicht und/oder einer Verbindungsschicht mit konstanter Dicke gedünnte Bereiche zum Beispiel durch Abtragen von Material, beispielsweise mittels Ätzen, oder durch Einprägen herzustellen. Dies ist jedoch nicht zwingend erforderlich. Beispielsweise kann die jeweilige Schicht von vornherein mit dünneren und dickeren Bereichen ausgebildet sein.

"Gedünnter Bereich" ist allgemein dadurch definiert, dass in ihm die Schichtdicke der Leiterschicht geringer ist als ihre maximale Schichtdicke, unabhängig von einem Herstellungsverfahren. Zweckmäßigerweise weist der gedünnte Bereich eine Dicke auf, die um mindestens 10 %, um mindestens 25 % oder um mindestens 35 % geringer ist als die maximale Dicke der Leiterschicht. Beispielsweise kann ein gedünnter Bereich eine Dicke aufweisen, die etwa 40 %, etwa 50 % oder etwa 60 % geringer als die maximale Dicke der Leiterschicht ist.

Gemäß mindestens einer Ausführungsform des Trägerkörpers ist die Verbindungsschicht Teil eines ersten Leadframes und die Leiterschicht Teil eines zweiten Leadframes. Die zwei Leadframes sind elektrisch isolierend miteinander verbunden. Wie eingangs bereits erwähnt, ist ein Leadframe, das auch Leiterrahmen genannt werden kann, eine Metallplatte, in der mehrere elektrische Anschlussleiter für ein Halbleiterbauelement enthalten sind, wobei die elektrischen Anschlussleiter in der Metallplatte durch entsprechende Aussparungen in der Platte ausgebildet und geformt sind. Der Ausdruck "Leadframe" ist dem Fachmann geläufig, insbesondere auch einem Fachmann auf dem Gebiet der Optoelektronik.

Der Ausdruck "Leiterschicht" impliziert nicht zwingend eine einstückige Schicht. Vielmehr kann die Leiterschicht auch mehrere voneinander beabstandete, nebeneinander angeordnete Teilschichten aufweisen. Analoges gilt für die Verbindungsschicht.

Gemaß der Ausführungsform des Trägerkörpers weist dieser eine erste Seite auf, wobei an der ersten Seite eine Kapselmasse an die Leiterschicht und die Verbindungsschicht angeformt ist, die ein Silikon aufweist. Mit anderen Worten bildet dann die Kapselmasse eine Gehäusemasse für die Leiter- und die Verbindungsschicht.

Silikone haben den Vorteil, bei Einstrahlung von kurzwelliger elektromagnetischer Strahlung deutlich geringer als andere Kapselmassen, beispielsweise Optoharze, zur altern. Ferner weisen Silikone eine erheblich gesteigerte Temperaturbeständigkeit als zum Beispiel Epoxide auf. Während Epoxide typischerweise bis maximal etwa 150° C erhitzt werden können ohne Schaden zu nehmen, ist dies bei Silikonen bis etwa 200° C möglich.

Vorzugsweise findet für die Kapselmasse ein Silikon Verwendung, welches einen Härtegrad im Bereich von Shore A=20 bis D=90 bei einem Brechungsindex von 1,41 bis 1,57 aufweist.

Dabei ist es möglich, dass die Kapselmasse aus einem oder mehreren der hier beschriebenen Silikone besteht, wobei zusätzlich in das Silikon strahlungsreflektierende oder strahlungsabsorbierende Füllstoffe wie beispielsweise TiO₂ oder Ruß eingebracht sein können.

Ferner kommen für die Kapselmasse auch Hybridmaterialien wie beispielsweise Mischungen von Silikonen und Epoxiden oder Mischungen von Silikonen mit anderen organischen Materialien, wie zum Beispiel Vinyl, oder acrylhaltigen Materialien in Betracht.

Hybridmaterialien der beschriebenen Art sind vorteilhaft strahlungsstabiler sowie thermisch stabiler als reine Epoxide und weisen zudem gute mechanische Eigenschaften (zum Beispiel Zähigkeit) im Vergleich zu reinen Silikonen auf.

Gemäß mindestens einer Ausführungsform des Trägerkörpers weist dieser eine zweite Seite auf, die der ersten Seite gegenüberliegt, wobei die Leiterschicht an der zweiten Seite in solchen Bereichen zumindest teilweise frei von der Kapselmasse und von elektrisch isolierendem Material ist, in denen an der ersten Seite Kapselmasse an die Leiterschicht angeformt ist. Vorzugsweise ist der Trägerkörper oberflächenmontierbar. Vorteilhaft kann über den freiliegenden Teil der Leiterschicht oder des Trägerkörpers, das heißt über die zweite Seite, eine externe elektrische Kontaktierung erfolgen.

Gemäß mindestens einer weiteren Ausführungsform des Trägerkörpers weist die Leiterschicht mindestens zwei elektrisch voneinander isolierte Teile auf, die einen ersten und einen zweiten elektrischen Anschlussleiter für ein Halbleiterbauelement bilden und die mittels zumindest eines Teils der Verbindungsschicht mechanisch miteinander verbunden sind. Wenn die Verbindungsschicht vollständig elektrisch leitfähig ist oder mit einem elektrisch leitfähigen Teil an beide elektrischen Anschlussleiter angrenzt, reicht es grundsätzlich aus, dass die Verbindungsschicht nur gegenüber einem der Anschlussleiter elektrisch isoliert ist, damit sie diese nicht elektrisch verbindet.

Gemäß der Ausführungsform des Trägerkörpers weisen sowohl die Verbindungsschicht als auch die Leiterschicht jeweils mindestens einen gedünnten Bereich auf, in dem ihre Schichtdicke geringer als ihre maximale Schichtdicke ist. Dadurch ist eine noch größere Flexibilität hinsichtlich der Ausbildung zusätzlicher Funktionen oder besonderer Formen und Strukturen in dem Trägerkörper ermöglicht.

Bei dieser Ausführungsform überlappt der gedünnte Bereich der Verbindungsschicht lateral mit dem gedünnten Bereich der Leiterschicht. Lateral bedeutet im Zusammenhang mit der vorliegenden Anmeldung eine Richtung, die parallel zu einer Haupterstreckungsebene der Leiterschicht, der Verbindungsschicht oder des Trägerkörpers verläuft.

Gemäß mindestens einer weiteren Ausführungsform weist die Verbindungsschicht und/oder die Leiterschicht mindestens einen Durchbruch auf. Der Durchbruch kann zum Beispiel ein Loch in der Schicht oder eine Aussparung sein, die sich durch die gesamte Dicke der Schicht erstreckt. Die Aussparung kann auf mindestens einer Seite offen sein, das heißt sie ist nicht notwendigerweise von allen Seiten lateral von Material der Schicht umgeben. In dem Fall, dass die Schicht mehrere voneinander beabstandete Teilschichten aufweist, ist die Aussparung eine Lücke zwischen den Teilschichten.

Gemäß mindestens einer Ausgestaltung dieser Ausführungsform weist die Verbindungsschicht und/oder die Leiterschicht einen gedünnten Bereich auf, der an den Durchbruch angrenzt.

Gemäß einer weiteren Ausgestaltung dieser Ausführungsform weist die Leiterschicht einen gedünnten Bereich auf, der lateral mit dem Durchbruch der Verbindungsschicht überlappt. Der Durchbruch und der gedünnte Bereich können vollständig miteinander überlappen. Sie können jedoch auch nur teilweise miteinander überlappen, das heißt der Durchbruch kann teilweise lateral versetzt zu dem gedünnten Bereich sein.

Gemäß einer weiteren Ausgestaltung ist eine Öffnungsfläche des Durchbruchs in einer Draufsicht auf die

Verbindungsschicht kleiner als eine Fläche des mit dem Durchbruch überlappenden gedünnten Bereichs der Leiterschicht in der Draufsicht. Draufsicht bedeutet einen Blickwinkel senkrecht zu einer Haupterstreckungsebene einer der Schichten oder des Trägerkörpers. Alternativ ist in Draufsicht die Öffnungsfläche des Durchbruchs größer als die Fläche des mit dem Durchbruch überlappenden gedünnten Bereichs der Leiterschicht, jeweils in Draufsicht gesehen.

Gemäß einer weiteren Ausführungsform weist die Verbindungsschicht einen Teil auf, der einen Teil der Leiterschicht lateral überragt, wobei ein Bereich zwischen dem Teil der Verbindungsschicht und dem lateral überragten Teil der Leiterschicht frei von Material des Trägerkörpers ist. Zwischen den Teilen ist insbesondere eine Lücke vorhanden.

Bei einer Ausgestaltung grenzt der Teil der Verbindungsschicht an den Durchbruch an.

Gemäß mindestens einer weiteren Ausgestaltung des Trägerkörpers ist an einem Rand ein Teil der Verbindungsschicht vorhanden, der einen Teil der Leiterschicht lateral überragt, wobei zwischen dem Teil der Verbindungsschicht und dem Teil der Leiterschicht ein Bereich ist, der frei von Material des Trägerkörpers ist. Insbesondere ist zwischen den Teilen eine Lücke vorhanden.

Mindestens eine weitere Ausführungsform des Trägerkörpers sieht vor, dass die Verbindungsschicht und die Leiterschicht mittels eines Verbindungsmittels miteinander verbunden sind. Das Verbindungsmittel ist in einer Ausgestaltung ein elektrisch isolierendes Material. Zusätzlich oder alternativ kann es ein thermisch gut leitendes Material sein. Das Verbindungsmittel kann mit Vorteil ein Klebstoff sein.

Gemäß mindestens einer weiteren Ausführungsform ist auf einem Teil der Leiterschicht ein Chipmontagebereich vorgesehen. Die Verbindungsschicht ist der Leiterschicht auf der Seite des Chipmontagebereiches nachgeordnet. Der Chipmontagebereich ist insbesondere in einer Vertiefung des Trägerkörpers vorgesehen oder ausgebildet.

Bei mindestens einer weiteren Ausführungsform des Trägerkörpers ist mindestens eine Innenwand vorhanden, deren Haupterstreckungsebene schräg zu einer Haupterstreckungsebene des Trägerkörpers oder der Leiterschicht verläuft und verglichen mit dieser Haupterstreckungsebene zu dem Chipmontagebereich hin gekippt ist. Eine derart ausgebildete Innenwand kann bei einem optoelektronischen Bauelement als Reflektor für eine von einem Halbleiterchip emittierte oder zu empfangende elektromagnetische Strahlung dienen.

Es wird ein Halbleiterbauelement gemäß dem anhängigen Anspruch 12, angegeben, das den Trägerkörper in mindestens einer seiner Ausführungsformen oder Ausgestaltungen aufweist.

Der Trägerkörper ist auf einer ersten Seite mit einem Halbleiterchip und mit einer Kapselmasse versehen, wobei die Kapselmasse den Halbleiterchip umschließt und an den Trägerkörper angeformt ist. Mit anderen Worten kann die Kapselmasse einstückig ausgebildet sein und verkapselt den Chip sowie stellenweise den Trägerkörper.

Das Halbleiterbauelement ist gemäß einer Ausführungsform ein optoelektronisches Halbleiterbauelement. Der Halbleiterchip ist dabei insbesondere geeignet, eine elektromagnetische Strahlung zu emittieren und/oder zu empfangen.

Gemäß mindestens einer weiteren Ausführungsform des Halbleiterbauelements ist der Trägerkörper auf einer der ersten Seite gegenüberliegenden zweiten Seite in einem lateral mit der Kapselmasse und/oder mit der Kapselmasse und dem Halbleiterchip überlappenden Bereich zumindest teilweise frei von der Kapselmasse und von etwaigem sonstigen isolierenden Material. Das heißt, dass der elektrische Anschlussleiter - also zum Beispiel die Leiterschicht oder der Trägerkörper - auf der zweiten Seite in solchen Bereichen zumindest teilweise frei von der Kapselmasse ist, in denen auf der gegenüberliegenden ersten Seite Kapselmasse vorhanden ist. Der freiliegende Teil des Trägerkörpers auf seiner zweiten Seite fungiert insbesondere als externer elektrischer Anschluss des Halbleiterbauelements.

Gemäß einer Ausgestaltung des Halbleiterbauelements ist der Trägerkörper auf der zweiten Seite vollständig frei von Kapselmasse.

Ausführungsformen, bei denen der Anschlussleiter im Bereich der Kapselmasse vollständig von dieser umschlossen ist und ein weiterer Teil des Anschlussleiters aus der Kapselmasse herausragt und auf eine Rückseite der Kapselmasse gebogen ist, fallen nicht unter die vorhergehend beschriebene Ausführungsform. Grundsätzlich kann das Halbleiterbauelement jedoch auch solche Merkmale aufweisen.

Gemäß einer weiteren Ausgestaltung des Halbleiterbauelements ist ein Bereich des Trägerkörpers auf der zweiten Seite, der lateral mit dem Halbleiterchip überlappt, frei von der Kapselmasse und auch frei von sonstigem elektrisch isolierendem Material.

Der Halbleiterchip ist insbesondere ein Leuchtdiodenchip, wobei der Ausdruck "Leuchtdiodenchip" nicht auf Chips beschränkt ist, die sichtbares Licht emittieren, sondern generell für alle Halbleiterchips verwendet wird, die elektromagnetische Strahlung emittieren. Der Halbleiterchip weist insbesondere eine epitaktische Halbleiterschichtenfolge auf, die eine aktive Schicht umfasst, in der die elektromagnetische Strahlung erzeugt wird.

Die Kapselmasse ist gemäß einer weiteren Ausführungsform zu einem Großteil oder vollständig strahlungsdurchlässig ausgebildet. Sie weist in den strahlungsdurchlässigen Teilen einen Transmissionsgrad von mindestens 50 %, bevorzugt von mindestens 70 %, für eine elektromagnetische Strahlung aus dem Wellenlängenspektrum des Halbleiterchips auf.

Gemäß mindestens einer weiteren Ausführungsform des Halbleiterbauelements überlappt der Trägerkörper vollständig oder zu mindestens 80 %, bevorzugt zu mindestens 90 %, lateral mit der Kapselmasse.

Es wird ein Verfahren, gemäß dem anhängigen Anspruch 14, zum Herstellen eines Trägerkörpers für ein Halbleiterbauelement angegeben. Bei dem Verfahren werden eine Verbindungsschicht und eine Leiterschicht bereitgestellt. Die Leiterschichten weisen jeweils voneinander abgewandte Hauptflächen auf. Die

Verbindungsschicht und die Leiterschicht werden über zwei ihrer Hauptflächen derart miteinander verbunden, dass diese Hauptflächen einander zugewandt sind. Das Verbinden der Verbindungsschicht und der Leiterschicht erfolgt insbesondere nach dem Bereitstellen der Leiterschichten. Weiterhin wird sowohl in der Verbindungsschicht als auch der Leiterschicht mindestens ein gedünnter Bereich ausgebildet, in dem die Schichtdicke der entsprechenden Leiterschicht geringer als ihre maximale Schichtdicke ist.

Die Schichten werden derart verbunden und/oder sind von ihrer Materialbeschaffenheit derart, dass sie elektrisch voneinander isoliert sind. Die Verbindungsschicht ist in Teilen oder vollständig elektrisch leitfähig oder elektrisch isolierend.

Das Ausbilden des gedünnten Bereichs kann vor oder nach dem Verbinden der Verbindungsschicht und der Leiterschicht miteinander erfolgen. Das Ausbilden des gedünnten Bereichs kann insbesondere auch während des Bereitstellens der entsprechenden Schicht, beispielsweise während der Herstellung der Schicht, erfolgen. Die Schicht kann von vornherein mit einem gedünnten Bereich ausgebildet werden. Der gedünnte Bereich kann jedoch insbesondere auch durch Materialabtragung oder durch Materialverformung ausgebildet werden.

Weitere Vorteile, bevorzugte Ausführungsformen und Weiterbildungen des Trägerkörpers, des Halbleiterbauelements und des Verfahrens ergeben sich aus den im Folgenden in Verbindung mit den Figuren erläuterten Ausführungsbeispielen.

Es zeigen:
- Figur 1: eine schematische Schnittansicht der Verbindungsschicht und der Leiterschicht während eines Verfahrensstadiums zur Herstellung des Trägerkörpers oder des Halbleiterbauelements gemäß eines Ausführungsbeispiels;
- Figur 2: eine schematische Schnittansicht des Trägerkörpers gemäß des Ausführungsbeispiels mit den in Figur 1 dargestellten Schichten;
- Figur 3: eine schematische Schnittansicht des Halbleiterbauelements gemäß eines Ausführungsbeispiels;
- Figur 4: eine schematische Schnittansicht des Halbleiterbauelements gemäß eines Ausführungsbeispiels , der nicht zum Gegenstand der beanspruchten Erfindung gehört;

- Figur 5: eine schematische Schnittansicht des Halbleiterbauelements gemäß eines weiteren Ausführungsbeispiels , der nicht zum Gegenstand der beanspruchten Erfindung gehört;
- Figur 6: eine schematische Schnittansicht des Halbleiterbauelements gemäß eines weiteren Ausführungsbeispiels, der nicht zum Gegenstand der beanspruchten Erfindung gehört;

- Figur 7: ein beispielhafter Ausschnitt des in Figur 6 dargestellten Bauelements in einer schematischen Schnittansicht;
- Figur 8: eine erste beispielhafte schematische Draufsicht auf das in Figur 3 dargestellte Halbleiterbauelement;
- Figur 9: eine zweite beispielhafte schematische Draufsicht auf das in Figur 3 dargestellte Halbleiterbauelement;
- Figur 10: eine schematische Draufsicht des Halbleiterbauelements gemäß eines fünften Ausführungsbeispiels; und
- Figur 11: eine schematische Draufsicht des Halbleiterbauelements gemäß eines sechsten Ausführungsbeispiels.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

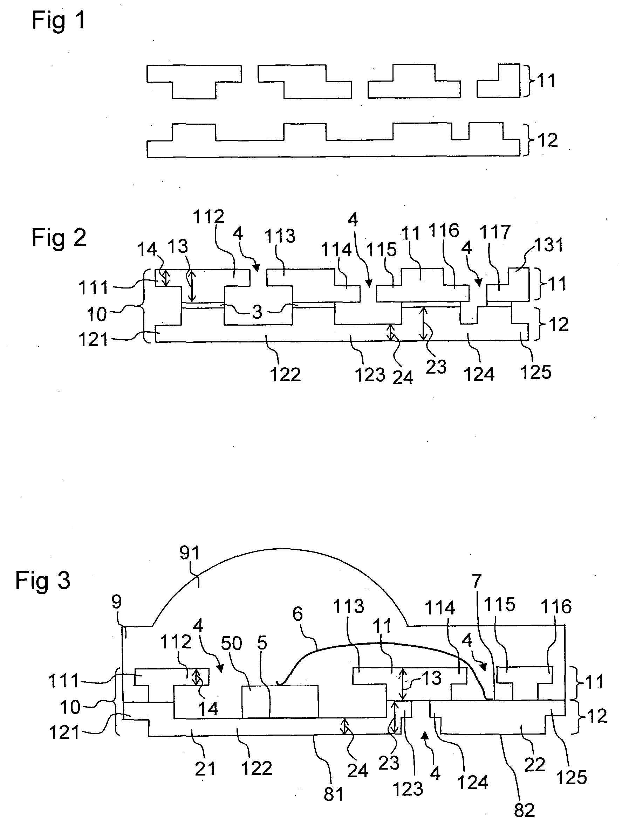

In Figur 1 sind eine Verbindungsschicht 11 und eine Leiterschicht 12 schematisch dargestellt. Sowohl die Verbindungsschicht als auch die Leiterschicht weisen mehrere gedünnte Bereiche auf, was nachfolgend im Zusammenhang mit Figur 2 erläutert wird. Die Verbindungsschicht 11 weist zudem mehrere Durchbrüche auf. Die Durchbrüche können beispielsweise als Löcher ausgebildet sein. Sie können aber auch Aussparungen sein, die auf mindestens einer Seite offen sind oder die die verschiedenen in Figur 1 sichtbaren Teile der Verbindungsschicht 11 voneinander trennen. Mit anderen Worten kann die Verbindungsschicht 11 auch mehrere voneinander separate Teile aufweisen. Gleiches gilt für die Leiterschicht 12.

Figuren 1 und 2 dienen hauptsächlich zur Veranschaulichung einiger Strukturen, die mit dem Trägerkörper mit Vorteil auf technisch einfache Weise realisierbar sind. Figur 2 stellt nicht zwingend einen Trägerkörper dar, der für ein Halbleiterbauelement optimiert ist, auch wenn er grundsätzlich für ein solches geeignet wäre.

Sowohl die Verbindungsschicht als auch die Leiterschicht weist beispielsweise elektrisch leitfähiges Material auf. Die Schichten können insbesondere auch vollständig aus elektrisch leitfähigem Material bestehen. Alternativ kann eine der Schichten oder können beide Schichten auch nur teilweise aus elektrisch leitfähigem Material bestehen. Bevorzugt besteht zumindest die Leiterschicht jedoch zu einem Großteil aus elektrisch leitfähigem Material, beispielsweise zu mehr als 50 %, mehr als 75 % oder mehr als 80 %. Gleiches kann für die Verbindungsschicht gelten.

Die Leiterschicht 12 und die Verbindungsschicht 11 weisen zum Beispiel metallisches Material auf oder bestehen aus einem solchen. Beide Schichten können beispielsweise zu einem Großteil aus Kupfer bestehen. Zusätzlich können die Leiterschichten zum Beispiel mit mindestens einem weiteren Metall, beispielsweise Gold, Silber oder Zinn beschichtet sein.

Die Verbindungsschicht 11 kann alternativ auch vollständig aus einem elektrisch isolierenden Material bestehen oder ein solches aufweisen. Beispiele für isolierende Materialien sind keramische Materialien oder Kunststoffe. Wenn die Verbindungsschicht 11 nur teilweise aus einem elektrisch isolierenden Material besteht, kann dieses beispielsweise derart in der Verbindungsschicht 11 integriert sein, dass der elektrisch leitfähige Teil der Verbindungsschicht 11 im Trägerkörper 10 auch dann elektrisch gegenüber der Leiterschicht isoliert ist, wenn die Schichten 11, 12 zum Beispiel mittels eines elektrisch leitfähigen Verbindungsmittels 3 miteinander verbunden sind, siehe Figur 2. Gleiches kann grundsätzlich auch für die Beschaffenheit der Leiterschicht gelten.

In einem zweckmäßigen Ausführungsbeispiel sind sowohl die Verbindungsschicht 11 und die Leiterschicht 12 Teile eine Leadframes, das zum Beispiel vollständig elektrisch isolierend mechanisch miteinander verbunden wird. Die Leadframes bestehen aus Metall und weisen zum Beispiel Kupfer auf.

Die maximale Dicke beider Schichten 11, 12 oder einer der Schichten beträgt beispielsweise 0,1 mm, 0,15 mm oder 0,2 mm. Insbesondere können eine Leiterschicht 12 und eine Verbindungsschicht 11 mit unterschiedlichen maximalen Dicken verwendet werden. Zum Beispiel kann die Verbindungsschicht 11 eine maximale Dicke 13 von etwa 0,15 mm aufweisen und die Leiterschicht 12 eine maximale Dicke 23 von 0,4 mm oder umgekehrt.

Zur Herstellung des Trägerkörpers 10 werden die Verbindungsschicht und die elektrische Leiterschicht 11, 12 mittels eines Verbindungsmaterials 3 miteinander verbunden, siehe Figur 2. Das Verbindungsmaterial 3 ist beispielsweise elektrisch isolierend, zum Beispiel ein Klebstoff. Es kann jedoch grundsätzlich auch beispielsweise ein elektrisch leitfähiges Verbindungsmittel 3 wie ein Lot oder ein elektrisch leitfähiger Klebstoff verwendet werden. Dies kann zum Beispiel davon abhängen, ob ein elektrisch isolierendes Verbindungsmittel dafür erforderlich ist, dass Teile der Leiterschicht, die im Trägerkörper eventuell voneinander isoliert sein sollen, elektrisch voneinander isoliert sind. Grundsätzlich kann auch ein elektrisch leitfähiges Verbindungsmittel mit einem elektrisch isolierenden kombiniert werden.

Zumindest einige der gedünnten Bereiche der Verbindungsschicht 11 sowie einige der Durchbrüche 4 könnten grundsätzlich auch erst erzeugt werden, nachdem die Verbindungsschicht 11 und die Leiterschicht 12 mittels des Verbindungsmittels 3 miteinander verbunden worden sind.

Wie in Figur 2 zu erkennen ist, lässt sich der Trägerkörper 10 durch die Verwendung von mindestens zwei Schichten 11, 12 auf technisch einfache Weise mit einer Vielzahl dreidimensionaler Strukturen versehen, die auf andere Weise nicht oder nur mit signifikant höherem Aufwand realisierbar wären. Grundsätzlich kann der Trägerkörper neben der Verbindungsschicht 11 und der Leiterschicht 12 noch weitere Schichten aufweisen, beispielsweise insgesamt drei oder vier Schichten.

Bei dem in Figur 2 dargestellten Trägerkörper 10 weist die Verbindungsschicht 11 an einem ersten Rand einen gedünnten Bereich 111 auf, der einen gedünnten Bereich 121 der Leiterschicht 12 lateral überragt. Zwischen dem gedünnten Bereich 111 der Verbindungsschicht und dem gedünnten Bereich 121 der Leiterschicht ist ein Bereich, der frei von Material des Trägerkörpers ist. Bei der Darstellung in Figur 2 ist der komplette Bereich zwischen den gedünnten Bereichen am Rand 111, 121 frei von Material des Anschlussleiters. Ein Teil dieses Bereiches könnte jedoch auch Material des Anschlussleiters aufweisen, beispielsweise könnte Verbindungsmaterial 3 in den Bereich hineinragen.

Eine derartige Lücke an einem Rand des Trägerkörpers kann bei einem herzustellenden Bauelement wie ein Verankerungselement für eine Kapselmasse wirken, mittels dem das Risiko einer Delamination von Kapselmasse und elektrischem Anschlussleiter deutlich verringert werden kann. Auch die anderen Strukturen des in Figur 2 dargestellten elektrischen Anschlussleiters können als ein Ankerelement für eine Kapselmasse wirken, wenn die jeweiligen Lücken zwischen Teilen der Verbindungsschicht 11 und der Leiterschicht 12 zumindest teilweise von einer Kapselmasse gefüllt werden.

Die in Figur 2 dargestellten gedünnten Bereiche 112, 113 der Verbindungsschicht 11 grenzen an einen Durchbruch 4 an. Zudem überragen sie jeweils lateral einen Teil eines gedünnten Bereiches 122 der Leiterschicht 12. Dazwischen ist jeweils eine Lücke. Zudem ist damit auch eine Vertiefung in dem Trägerkörper 10 ausgebildet. Die Querschnittsfläche der Vertiefung vergrößert sich, gesehen in einer Draufsicht, im Verlauf von einer Außenseite der Verbindungsschicht 11 zur Leiterschicht 12 hin.

Derartige Vertiefungen können zum Beispiel als reines Ankerelement des Trägerkörpers 10 verwendet werden, das heißt die Vertiefung kann bei einem Halbleiterbauelement frei von einem Halbleiterchip sein. Zudem kann der Boden einer derartigen Vertiefung jedoch auch als Montagefläche für einen Halbleiterchip verwendet werden, der entsprechend in der Vertiefung angeordnet ist.

In der Mitte des Trägerkörpers 10 gemäß Figur 2 ist eine weitere Vertiefung ausgebildet. Gedünnte Bereiche 114, 115 der Verbindungsschicht grenzen bei dieser Vertiefung an einen Durchbruch 4 an und überragen einen gedünnten Bereich 123 der Leiterschicht 12 lateral. Zwischen den gedünnten Bereichen 114, 115 der Verbindungsschicht 11 und dem gedünnten Bereich 123 der Leiterschicht 12 ist eine Lücke. Im Unterschied zu der vorhergehend beschriebenen Vertiefung weist diese Vertiefung einen anderen Verlauf der Größe der Querschnittsfläche auf. Ausgehend von der Außenseite der Verbindungsschicht 11 verkleinert sich die Querschnittsfläche der Vertiefung innerhalb des Durchbruchs zunächst, um im Bereich der Leiterschicht 12 wieder größer zu werden.

Die an den Durchbruch 4 angrenzenden gedünnten Bereiche 114, 115 der Verbindungsschicht sind im Unterschied zu den gedünnten Bereichen 112, 113 in einem Teil der Leiterschicht 11 ausgebildet, der zu der Leiterschicht 12 hin gewandt ist und der eine Hauptfläche der Verbindungsschicht 11 bildet, über die die Verbindungsschicht 11 mit der Leiterschicht 12 verbunden ist.

Bei dem in Figur 2 dargestellten Ausführungsbeispiel eines Trägerkörpers ist ein weiterer gedünnter Bereich 116 der Verbindungsschicht 11 vorhanden, der einen Teil der Leiterschicht 12 lateral überragt. Dabei ist jedoch nur ein Teil des Bereichs zwischen dem gedünnten Bereich 116 und dem von diesem überragten Teil der Leiterschicht 12 frei von Material des Trägerkörpers 10. Dies ist dadurch realisiert, dass ein gedünnter Bereich 124 der Leiterschicht 12 nur teilweise mit dem gedünnten Bereich 116 überlappt. Der gedünnte Bereich 124 der Leiterschicht 12 überlappt auch nur teilweise lateral mit einem weiteren Durchbruch 4, an den der gedünnte Bereich 116 angrenzt.

Durch derartige teilweise laterale Überlappungen können in dem Trägerkörper 10 effektiv kleinere Strukturelemente, wie zum Beispiel wegragende Teile oder Öffnungen, ausgebildet werden als jeweils in einer der Schichten 11, 12. Wenn zum Beispiel die gedünnten Bereiche und die Durchbrüche mittels Ätzen in Leiterschichten aus Metall hergestellt werden, dann liegt eine Mindestgröße einer lateralen Ausdehnung der gedünnte Bereiche und des Durchbruchs in der Größenordnung der maximalen Dicke der unstrukturierten Leiterschicht.

An einem zweiten Rand des Trägerkörpers 10 weist die Verbindungsschicht 11 einen ungedünnten Teil 118 auf, der einen Teil 125 der Leiterschicht 12 lateral überragt, wobei zwischen diesen Teilen 118, 125 der Leiterschichten 11, 12 eine Lücke besteht. Auch diese kann als Verankerungselement für eine Kapselmasse dienen.

In den Figuren 3 bis 6 ist jeweils ein Ausführungsbeispiel eines Halbleiterbauelements veranschaulicht. Das Halbleiterbauelement ist beispielsweise ein optoelektronisches Bauelement, zum Beispiel ein Leuchtdiodenbauelement. Es weist jeweils einen Trägerkörper 10 auf.

Der Trägerkörper 10 enthält eine Leiterschicht 12, die in einem ersten Teil einen ersten elektrischen Anschlussleiter 21 und in einem zweiten Teil einen zweiten elektrischen Anschlussleiter 22 bildet. Der erste elektrische Anschlussleiter 21 weist jeweils einen Chipmontagebereich 5 auf, auf dem ein Halbleiterchip 50 mechanisch und elektrisch leitend montiert ist. Die Anschlussleiter 21, 22 sind elektrisch voneinander isoliert, sie sind zum Beispiel lateral voneinander beabstandet.

Der Trägerkörper 10 enthält zudem eine Verbindungsschicht 11. Diese verbindet zum Beispiel die elektrischen Anschlussleiter 21, 22 mechanisch, nicht jedoch elektrisch miteinander.

Der Halbleiterchip 50 ist zum Beispiel ein Leuchtdiodenchip. Dieser weist zum Beispiel eine epitaktische Halbleiterschichtenfolge auf, die eine aktive Schicht umfasst. Die aktive Schicht kann insbesondere aus mehreren Teilschichten zusammen gesetzt sein, die insbesondere auch unterschiedliche Materialzusammensetzungen aufweisen können.

Die Halbleiterschichtenfolge weist beispielsweise III/V-Verbindungs-Halbleitermaterialien auf. Ein III/V-Verbindungs-Halbleitermaterial weist wenigstens ein Element aus der dritten Hauptgruppe, wie beispielsweise B, Al, Ga, In, und ein Element aus der fünften Hauptgruppe, wie beispielsweise N, P, As, auf. Insbesondere umfasst der Begriff "III/V-Verbindungs-Halbleitermaterial" die Gruppe der binären, ternären oder quaternären Verbindungen, die wenigstens ein Element aus der dritten Hauptgruppe und wenigstens ein Element aus der fünften Hauptgruppe enthalten, beispielsweise Nitrid- und Phosphid-Verbindungshalbleiter. Eine solche binäre, ternäre oder quaternäre Verbindung kann zudem zum Beispiel ein oder mehrere Dotierstoffe sowie zusätzliche Bestandteile aufweisen.

Die aktive Schicht umfasst bevorzugt einen pn-Übergang, eine Doppelheterostruktur, einen Einfach-Quantentopf (SQW, single quantum well) oder, besonders bevorzugt, eine Mehrfach-Quantentopfstruktur (MQW, multi quantum well) zur Strahlungserzeugung. Die Bezeichnung Quantentopfstruktur entfaltet hierbei keine Bedeutung hinsichtlich der Dimensionalität der Quantisierung. Sie umfasst somit unter anderem Quantentröge, Quantendrähte und Quantenpunkte und jede Kombination dieser Strukturen. Beispiele für MQW-Strukturen sind dem Fachmann bekannt.

Bei den in den Figuren veranschaulichten Ausführungsbeispielen ist der Chipmontagebereich 5 jeweils auf einer Außenfläche der Leiterschicht 12 des ersten Trägerkörpers 10 ausgebildet. Die Verbindungsschicht 11 folgt der Leiterschicht 12 auf der Seite des Chipmontagebereichs 5 nach. Somit ist der Halbleiterchip 50 jeweils zumindest teilweise lateral von Material des Trägerkörpers 10 umgeben. Mit anderen Worten ist er in einer Vertiefung des Trägerkörpers 10 angeordnet.

Auf der Seite des Chipmontagebereiches 5 und des Halbleiterchips 50 sind der Trägerkörper 10 und der Halbleiterchip 50 mit einer Kapselmasse 9 des Halbleiterbauelements versehen. Die Kapselmasse 9 kapselt den Halbleiterchip 50 ein und ist an den Trägerkörper 10 angeformt. Auf einer den Chipmontagebereich 5 gegenüberliegenden Seite des Trägerkörpers 10 ist dieser frei von der Kapselmasse sowie von sonstigem elektrisch isolierendem Material. Dieser Bereich der Außenfläche des Trägerkörpers 10 dient beispielsweise im Bereich des ersten Anschlussleiters 21 als eine erste externe elektrische Kontaktfläche 81 und im Bereich des zweiten Anschlussleiters 22 als zweite externe elektrische Kontaktfläche des Halbleiterbauelements.

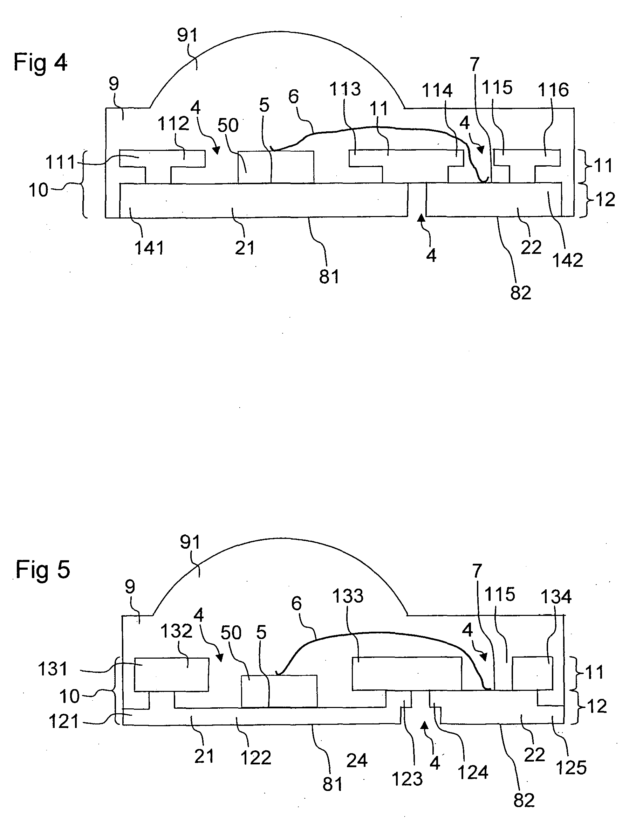

Zwischen den elektrischen Anschlussleitern 21, 22 ist jeweils ein Durchbruch 4 der Leiterschicht 12 vorhanden, der die elektrischen Anschlussleiter voneinander trennt. Bei den Ausführungsbeispielen gemäß der Figuren 3, 5 und 6 grenzen an den Durchbruch 4 gedünnte Teile 123, 124 der Leiterschicht, so dass der Querschnitt des Durchbruchs im Verlauf zur Verbindungsschicht 11 hin kleiner wird. Außen ist der Abstand zwischen der elektrischen Anschlussleitern 21, 22 somit größer als in der Nähe der Verbindungsschicht, wodurch Kurzschlüssen bei der elektrischen Montage des Halbleiterbauelements vorgebeugt werden kann, ohne dass die Stabilität des Trägerkörpers 10 signifikant beeinträchtigt wird. In Figur 4 weist der gesamte Durchbruch 4 der Leiterschicht 12 zum Beispiel eine konstante Querschnittsfläche auf.

Bei den in den Figuren 3, 5 und 6 veranschaulichten Ausführungsbeispielen ist der Chipmontagebereich 5 auf einer Außenfläche eines gedünnten Bereiches 122 der Leiterschicht 12 ausgebildet.

Wenn der Chipmontagebereich 5 auf einer Außenfläche eines gedünnten Bereiches 122 der Leiterschicht 12 ausgebildet ist, lässt sich der Abstand zwischen dem Chipmontagebereich 5 und der externen elektrischen Anschlussfläche 81 mit Vorteil besonders klein realisieren. Dadurch lässt sich ein besonders geringer thermischer Widerstand zwischen dem Halbleiterchip 50 und der elektrischen Anschlussfläche 81 erreichen, was sich positiv auf den Betrieb, die Leistung und die Beständigkeit des Halbleiterbauelements auswirken kann.

Ein besonders geringer thermischer Widerstand kann in der Regel jedoch immer dann realisiert werden, wenn der Chipmontagebereich 5 auf einer Außenfläche der Leiterschicht (das heißt der "unteren", von der Hauptabstrahlrichtung abgewandten Schicht) ausgebildet ist, unabhängig davon, ob der Chipmontagebereich in einem ungedünnten oder einem gedünnten Bereich ausgebildet ist. Wenn zum Beispiel die Leiterschicht im Wesentlichen aus Kupfer besteht, spielt die Dicke der Leiterschicht für den thermischen Widerstand nur eine geringe Rolle.

Bei dem in Figuren 4 veranschaulichten Ausführungsbeispiel des Halbleiterbauelements ist der Chipmontagebereich 5 auf einer Außenfläche eines Teils der Leiterschicht 12 ausgebildet, dessen Dicke einer maximalen Dicke 23 der Leiterschicht entspricht.

Das Halbleiterbauelement gemäß Figur 4 weist zum Beispiel eine Leiterschicht 12 des Trägerkörpers 10 auf, die keine gedünnten Bereiche enthält. In diesem Fall kann die Leiterschicht 12 zum Beispiel aus einer Metallplatte mit im Wesentlichen konstanter Dicke gebildet sein. Die Verbindungsschicht 11 des in Figur 5 dargestellten Ausführungsbeispiels weist zum Beispiel ebenfalls keine gedünnten Bereiche auf. In diesen Ausführungsbeispielen muss somit nur eine der beiden Schichten mit gedünnten Bereichen versehen werden, was die Herstellung vereinfachen kann.

Bei den in den Figuren 3, 4, und 5 veranschaulichten Ausführungsbeispielen ist jeweils die Vertiefung, in der der Halbleiterchip 50 angeordnet ist, als ein Verankerungselement ausgebildet, bei denen zwischen Teilen der Verbindungsschicht 11 und von diesen lateral überragten Teilen der Leiterschicht 12 Lücken vorhanden sind, die von der Kapselmasse 9 ausgefüllt sind.

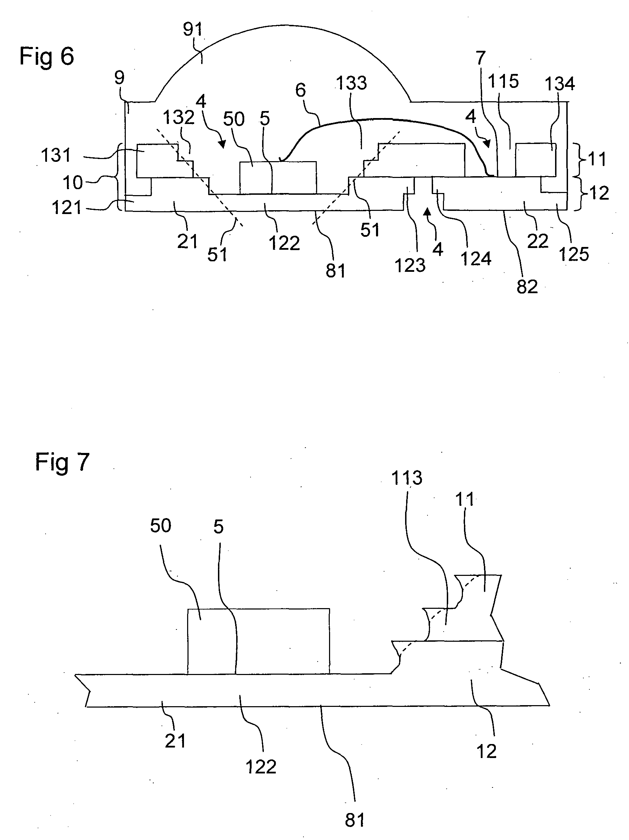

Im Unterschied dazu weist das in Figur 6 veranschaulichte beispielhafte Halbleiterbauelement eine Vertiefung mit Rändern auf, die als Reflektoren fungieren können. Bei dem Ausführungsbeispiel gemäß Figur 6 ist der Chipmontagebereich 5 von mindestens zwei Innenwänden der Vertiefung umgeben, deren Haupterstreckungsebene 51 schräg zu einer Haupterstreckungsebene des Trägerkörpers 10 verläuft und verglichen mit der Haupterstreckungsebene des Trägerkörpers 10 zu dem Chipmontagebereich 5 hin gekippt ist.

In Figur 6 sind die Innenwände derart dargestellt, dass sie aus mehreren rechteckigen Stufen gebildet sind. In Realität handelt es sich jedoch in aller Regel nicht um rechteckige Stufen, sondern um teilweise gewölbte und abgerundete Flächen. Konkave Wölbungen entstehen beispielsweise, wenn man den Durchbruch 4, die gedünnten Bereiche 112, 113 der Verbindungsschicht und den gedünnten Bereich 122 der Leiterschicht 121 in einer Metallplatte von im Wesentlichen konstanter Dicke mittels Ätzen ausbildet. Eine schematische beispielhafte Darstellung derartiger konkaver Wölbungen der Stufen einer Innenwand ist in dem in Figur 7 gezeigten Ausschnitt gegeben.

Die Innenwände können auch auf andere Weise ausgebildet werden. Zudem können zusätzliche Maßnahmen getroffen werden, um die Innenwände zu glätten. In Figur 12 ist mittels gestrichelter Linien beispielhaft veranschaulicht, wie der Verlauf oder die Form einer geglätteten Innenwand aussehen könnte. Ein Glätten oder Entfernen der Kanten kann zum Beispiel mittels Elektropolieren oder ähnlichen Verfahren erfolgen. Die Innenwände werden weitgehend so geformt, dass an Ihnen elektromagnetische Strahlung des Halbleiterchips 50 in eine Abstrahlrichtung des Halbleiterbauelements abgelenkt werden kann.

Wenn Innenwände des Anschlussleiters 10 als Reflektor ausgebildet sind, wie in den Figuren 6 und 7 beispielhaft veranschaulicht, dann ist es vorteilhaft, wenn der Boden der Vertiefung, auf dem der Chipmontagebereich 50 ausgebildet ist, möglichst tief ist, damit die "Reflektoren" möglichst hoch über den Chip 5 reichen. Beispielsweise ist der gedünnnte Bereich 122 der Leiterschicht 12 um mindestens 60 %, um mindestens 70 % oder um mindestens 80 % dünner als die maximale Dicke der Leiterschicht. Zusätzlich oder alternativ weist der gesamte Trägerkörper 10 zum Beispiel eine Gesamtdicke von mindestens 0,5 mm, von mindestens 0,75 mm oder mindestens 1 mm auf. Die Gesamtdicke des Trägerkörpers 10 kann insgesamt zum Beispiel maximal 1 mm dick sein.

Die Kapselmasse 9 weist beispielsweise Silikon auf oder besteht zumindest zu einem Großteil aus diesem. Ein Teil der Kapselmasse 9 ist zum Beispiel zu einer Linse 91 geformt. Die Kapselmasse 9 umschließt zum Beispiel den Trägerkörper 10 und den zweiten elektrischen Anschlussleiter 20 jeweils lateral vollständig und bedeckt die Anschlussleiter 10, 20 von einer Seite her vollständig, wie in Figur 4 dargestellt.

Alternativ umschließt die Kapselmasse 9 die Leiterschicht 12 lateral nicht, wie in Figur 3 dargestellt, oder umschließt sie lateral nur teilweise, wie in den Figuren 5 und 6 dargestellt. In diesen Beispielen ist die Kapselmasse zum Beispiel vertikal von den externen Anschlussflächen 81, 82 beabstandet

Die Kapselmasse 9 kann zum Beispiel eine vom Halbleiterchip 50 abgewandte Seite des Trägerkörpers, entgegen der Veranschaulichungen in den Figuren, zu einem Teil ebenfalls bedecken. Ein Teil der externen Anschlussflächen 81, 82 der elektrischen Anschlussleiter 21, 22 bleibt jedoch auch in diesem Fall frei von der Kapselmasse 9 und bildet im Falle des ersten Anschlussleiters 21 eine elektrische Anschlussfläche 81 und im Falle des zweiten elektrischen Anschlussleiters 22 eine elektrische Anschlussfläche 82.

Der Halbleiterchip 50 ist beispielsweise mittels eines Bonddrahtes 6 elektrisch leitend mit einer internen elektrischen Anschlussfläche 7 des zweiten elektrischen Anschlussleiters 22 verbunden. Auf einer der internen elektrischen Anschlussfläche 7 gegenüberliegenden Seite weist der zweite elektrische Anschlussleiter eine externe elektrische Anschlussfläche 82 auf, die frei von isolierendem Material ist. Statt eines Bonddrahtes 6 können grundsätzlich auch andere elektrische Verbindungsmittel zum elektrisch leitenden Verbinden des Halbleiterchips 50 mit dem zweiten elektrischen Anschlussleiter 22 verwendet werden.

Der Trägerkörper weist in allen Ausführungsbeispielen an den Rändern jeweils einen Teil 111, 131, 116, 134 der Verbindungsschicht 11 auf, der einen Teil 121, 125, 141, 142 der Leiterschicht 12 lateral überragt, wobei zwischen den jeweiligen Teilen eine Lücke vorhanden ist, die frei von Material des Trägerkörpers ist. Bei den Beispielen gemäß der Figuren 3, 5 und 6 werden die Teile 121, 125 der Leiterschicht an den Rändern des Trägerkörpers 10 im Bereich der Lücke zum Beispiel nur teilweise lateral von der Verbindungsschicht 11 überragt. Ein weiterer, äußerer Teil der Leiterschicht 12 ist dagegen lateral zu der Verbindungsschicht 11 versetzt.

Im Bereich des zweiten Anschlussleiters 22 weist die Verbindungsschicht 11 jeweils einen Durchbruch 4 auf. Dadurch ist die interne Kontaktfläche 7 von der Seite der Verbindungsschicht 11 her kontaktierbar. Bei den in Figur 5 und 6 dargestellten Ausführungsbeispielen weist dieser Durchbruch 4 zum Beispiel jeweils eine konstante Querschnittsfläche auf, gesehen in Draufsicht.

Bei den in Figur 3 und 4 dargestellten Ausführungsbeispielen sind die Vertiefungen jedoch analog zu der Vertiefung im Bereich des ersten Anschlussleiters 21 als Verankerungselement oder mit Verankerungselementen für die Kapselmasse 9 ausgebildet. In diesem Fall vergrößert sich der Querschnitt des Durchbruchs 4 im Verlauf zur Leiterschicht hin. Teile 114, 115 der Verbindungsschicht 11 überragen Teile der Leiterschicht 12 lateral und zwischen diesen Teilen ist jeweils eine Lücke vorhanden, die frei von Material des Trägerkörpers ist.

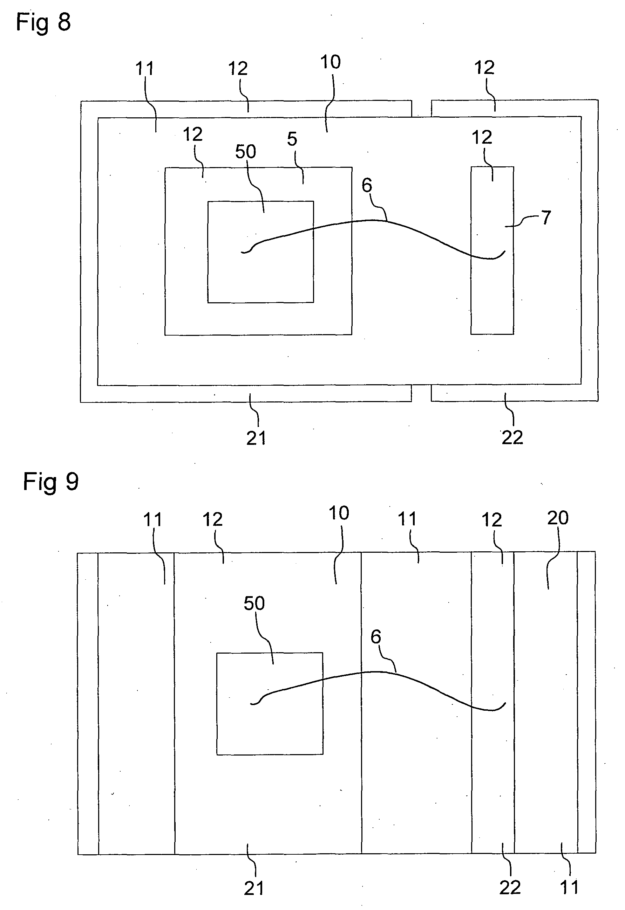

In Figur 8 ist ein erstes Ausführungsbeispiel einer Draufsicht auf das in Figur 3 dargestellte Halbleiterbauelement. Bei diesem Ausführungsbeispiel ist der Halbleiterchip 50 lateral vollständig von der Verbindungsschicht 11 und gegebenenfalls von Teilen der Leiterschicht 12 umgeben. Mit anderen Worten ist eine Vertiefung des Trägerkörpers 10 vorhanden, in dem der Halbleiterchip 50 angeordnet ist, die auf allen Seiten Innenwände aufweist. Eine solche Vertiefung ist beispielsweise auch im Bereich des zweiten Anschlussleiters 22 vorhanden.

Im Unterschied dazu ist bei der in Figur 9 dargestellten Draufsicht die Vertiefung, in der der Halbleiterchip 50 angeordnet ist, ein an zwei gegenüberliegenden Seiten offener Graben. Entsprechendes gilt zum Beispiel für die Vertiefung im Bereich des zweiten Anschlussleiters 22. Bei einem derartigen Ausführungsbeispiel könnte die Schnittansicht gemäß Figur 3 alternativ auch eine seitliche Draufsicht auf das Halbleiterbauelement sein, da die Vertiefung an zwei Seiten seitlich offen ist. Die Vertiefung kann alternativ auch nur auf einer Seite seitlich offen sein.

Bei allen Ausführungsbeispielen können die Leiterschicht und die Verbindungsschicht mit unterschiedlichen Materialien, Metallisierungen, Materialsvergütungen und/oder Oberflächenrauheiten ausgebildet sein. Beispielsweise weist die Oberfläche der Verbindungsschicht zumindest in Teilbereichen eine um mindestens 50 %, mindestens 100 % oder mindestens 150 % größere Rauheit auf als die Oberfläche der Leiterschicht.

Die Leiterschicht weist zum Beispiel eine Metallbeschichtung auf, zum Beispiel Schichtenfolge mit verschiedenen Metallschichten. Die Schichtenfolge weist zum Beispiel ausgehend von einem Grundkörper der Leiterschicht in dieser Reihenfolge eine Nickel-, eine Palladium- und eine Goldschicht auf, wobei jede der Schichten zusätzlich auch andere Materialien aufweisen kann außer Nickel, Palladium und Gold. Es sind insbesondere Legierungen möglich. Eine derartige Metallbeschichtung weist zum Beispiel eine gute Eignung zum Löten und Kleben sowie zum Bonden von Bonddrähten auf.

Die Leiterschicht weist zum Beispiel einen Grundkörper auf, der Kupfer aufweist oder aus Kupfer besteht. Zusätzlich oder alternativ weist die Verbindungsschicht zum Großteil Kupfer auf oder besteht die Verbindungsschicht vollständig aus Kupfer. Die Oberfläche von Kupfer oxidiert schnell und weist im oxidierten Zustand eine gute Haftung zu Kapselmassen auf, wie zum Beispiel Kapselmassen, die Silikon aufweisen oder aus Silikon bestehen. Die Verbindungsschicht kann jedoch ebenfalls eine Metallbeschichtung aufweisen, analog der vorhergehend beschriebenen Metallbeschichtung der Leiterschicht.

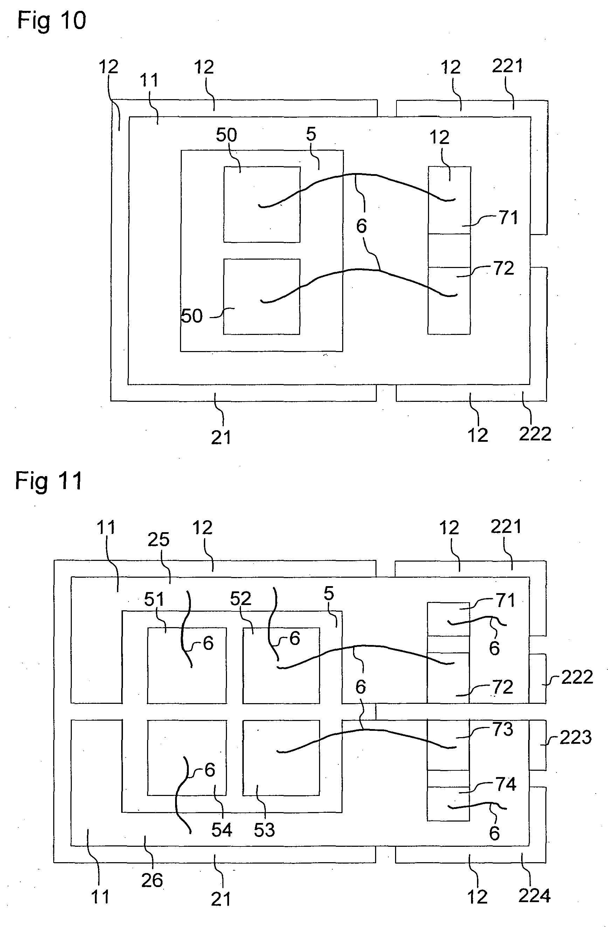

Bei den in den Figuren 10 und 11 veranschaulichten Ausführungsbeispielen weist das Halbleiterbauelement jeweils mehrere Halbleiterchips 50, 51, 52, 53, 54 auf. Das Halbleiterbauelement ist beispielsweise derart ausgebildet, dass zumindest einige der Halbleiterchips oder alle Halbleiterchips extern unabhängig voneinander ansteuerbar sind.

Dies ist beispielsweise dadurch realisiert, dass die Leiterschicht 12 mindestens drei elektrisch voneinander isolierte Teile 21, 221, 222 aufweist, wie in Figur 10 dargestellt. Ein erster Teil 21 der Leiterschicht 12 dient zum Beispiel als erster Anschlussleiter, auf dem die Halbleiterchips 50 mechanisch und mit einer Anschlussseite auch elektrisch leitend mit der Anschlussfläche 5 des ersten elektrischen Anschlussleiters 21 verbunden sind. Die Halbleiterchips 50 sind beispielsweise auf dem ersten Anschlussleiter 21 aufgelötet.

Ein zweiter Teil 221 der Leiterschicht 12 dient zum Beispiel als zweiter elektrischer Anschlussleiter und ein dritter Teil 222 der Leiterschicht 12 dient zum Beispiel als dritter elektrischer Anschlussleiter des Trägerkörpers und des Bauelements. Einer der Halbleiterchips 50 ist beispielsweise elektrisch leitend mit dem zweiten Anschlussleiter 221 elektrisch leitend verbunden, zum Beispiel mittels eines Bonddrahtes 6 oder mittels eines anderen elektrischen Verbindungsmittels. Der zweite der Halbleiterchips 50 ist beispielsweise elektrisch leitend mit dem dritten Anschlussleiter 222 elektrisch leitend verbunden, zum Beispiel ebenfalls mittels eines Bonddrahtes 6 oder mittels eines anderen elektrischen Verbindungsmittels.

Alle Teile der Leiterschicht 12 sind zum Beispiel mechanisch mittels der Verbindungsschicht 11 miteinander verbunden.

Zumindest einige der Halbleiterchips können grundsätzlich auch mittelbar über die Verbindungsschicht elektrisch leitend mit elektrischen Anschlussleitern des Trägerkörpers verbunden sein. Zum Beispiel ist mindestens ein Halbleiterchip elektrisch leitend mit der Verbindungsschicht verbunden und die Verbindungsschicht elektrisch leitend mit dem entsprechenden Anschlussleiter.

Ein Beispiel dafür ist in Figur 11 veranschaulicht. Das Halbleiterbauelement weist zum Beispiel vier Halbleiterchips 51, 52, 53, 54 auf, die alle auf einem ersten Anschlussleiter 21 der Leiterschicht 12 montiert sind. Die Leiterschicht 12 weist zum Beispiel 5 elektrisch voneinander isolierte elektrische Anschlussleiter 21, 221, 222, 223, 224 auf. Die Verbindungsschicht weist zum Beispiel zwei elektrisch voneinander isolierte und elektrisch leitfähige Teile 25, 26 auf. Die zwei Teile 25, 26 der Verbindungsschicht verbinden die Anschlussleiter 21, 221, 222, 223, 224 mechanisch miteinander. Der erste Anschlussleiter 21 verbindet die zwei Teile 25, 26 der Verbindungsschicht mechanisch miteinander, so dass der Trägerkörper des Bauelements ein zusammenhängendes Teil ist.

Ein erster Halbleiterchip 51 ist mittelbar über die Verbindungsschicht 11 mit einem zweiten Anschlussleiter 221 der Leiterschicht 12 elektrisch leitend verbunden. Die Verbindungsschicht kann zum Beispiel mittels eines Bonddrahtes 6 mit einer internen Anschlussfläche 71 des zweiten Anschlussleiters 221 elektrisch verbunden sein. Alternativ kann zwischen der Verbindungsschicht 11 und dem zweiten Anschlussleiter 221 ein elektrisch leitfähiges Verbindungsmittel angeordnet sein, das diesen Teil 25 der Verbindungsschicht 11 und den Anschlussleiter 224 elektrisch leitend miteinander verbindet. Analoges gilt für den zweiten Teil 26 der Verbindungsschicht, der elektrisch gegenüber dem ersten Teil 25 isoliert ist, und einen fünften Anschlussleiter 224 der Leiterschicht 12. Ein vierter Halbleiterchip 54 ist mittelbar über den zweiten Teil 26 der Verbindungsschicht 11 elektrisch leitend mit dem fünften Anschlussleiter 224 verbunden.

Ein zweiter Halbleiterchip 52 ist unmittelbar mittels eines Verbindungsmittels wie eines Bonddrahtes 6 elektrisch mit einem dritten elektrischen Anschlussleiter 222 verbunden. Ein dritter Halbleiterchip 53 ist unmittelbar mittels eines Verbindungsmittels wie eines Bonddrahtes 6 elektrisch mit einem vierten elektrischen Anschlussleiter 223 der Leiterschicht verbunden.

Der zweite Halbleiterchip 52 kann optional zusätzlich elektrisch leitend mit dem zweiten Anschlussleiter verbunden sein, zum Beispiel mittelbar über den ersten Teil 25 der Verbindungsschicht 11. Dadurch werden sowohl der erste Halbleiterchip 51 als auch der zweite Halbleiterchip 52 in Betrieb genommen, wenn zwischen dem ersten Anschlussleiter 21 und dem zweiten Anschlussleiter 221 eine elektrische Spannung angelegt wird. Unabhängig davon kann auch nur der zweite Halbleiterchip alleine über den ersten und den dritten Anschlussleiter 21, 222 in Betrieb genommen werden.

Was die elektrischen Verschaltungen angeht, sind beliebige Kombinationen der beschriebenen Merkmale möglich. Die Anzahl der Halbleiterchips und der Anschlussleiter ist nicht beschränkt. Auch kann die Verbindungsschicht mehr als zwei elektrisch voneinander isolierte Teile aufweisen.

Die Erfindung ist nicht durch die Beschreibung der Erfindung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Trägerkörper (10) für ein Halbleiterbauelement, mit einer elektrisch leitfähigen Leiterschicht (12) und einer Verbindungsschicht (11) , die über einander zugewandten Hauptflächen miteinander verbunden sind,
wobei die Verbindungsschicht (11) vollständig elektrisch leitfähig ist und zumindest gegenüber Teilen der Leiterschicht (12) elektrisch isoliert ist oder die Verbindungsschicht (11) zumindest in Teilen elektrisch isolierend ist,
wobei die Leiterschicht (12) und die Verbindungsschicht (11) jeweils mindestens einen gedünnten Bereich (111, 112, 113, 114, 115, 116, 121, 122, 123, 124, 125) aufweisen, in dem ihre Schichtdicke (14, 24) geringer als ihre maximale Schichtdicke (13, 23) ist,
wobei sowohl der Trägerkörper (10) als auch die Leiterschicht (12) und die Verbindungsschicht (11) für sich selbsttragende Elemente sind,
wobei der Trägerkörper eine erste Seite aufweist, an der eine Kapselmasse (9) an die Leiterschicht (12) und die Verbindungsschicht (11) angeformt ist, die ein Silikon aufweist,
wobei der gedünnte Bereich (121, 122, 123, 124, 125) der Leiterschicht lateral mit dem gedünnten Bereich (111, 112, 113, 114, 115, 116) der Verbindungsschicht überlappt und
wobei eine Lücke zwischen den überlappenden gedünnten Bereichen der Leiterschicht und der Verbindungsschicht vorhanden ist, die von der Kapselmasse (9) ausgefüllt ist.

2. Trägerkörper gemäß Anspruch 1,
wobei das Silikon einen Härtegrad im Bereich von Shore A=20 bis D=90 bei einem Brechungsindex von 1,41 bis 1,57 aufweist.

3. Trägerkörper gemäß Anspruch 1 oder 2,
aufweisend eine zweite Seite, die der ersten Seite gegenüber liegt,
wobei die Leiterschicht (12)
an der zweiten Seite in solchen Bereichen zumindest teilweise frei von der Kapselmasse und von elektrisch isolierendem Material ist, in denen an der ersten Seite Kapselmasse an die Leiterschicht angeformt ist.

4. Trägerkörper gemäß einem der vorhergehenden Ansprüche, wobei die Leiterschicht (12)
mindestens zwei elektrisch
voneinander isolierte Teile (21, 22) aufweist, die einen ersten
und einen zweiten elektrischen Anschlussleiter für ein Halbleiterbauelement bilden und die mittels zumindest eines Teils der Verbindungsschicht (11) mechanisch
miteinander verbunden sind.

5. Trägerkörper gemäß einem der vorhergehenden Ansprüche, wobei die Leiterschicht Teil eines ersten Leadframes ist, die
Verbindungsschicht Teil eines zweiten Leadframes ist und die zwei Leadframes elektrisch isolierend miteinander verbunden sind.

6. Trägerkörper gemäß einem der vorhergehenden Ansprüche, wobei die Verbindungsschicht und/oder die Leiterschicht einen Durchbruch (4)
und einen gedünnten Bereich, der an den Durchbruch angrenzt, aufweist.

7. Trägerkörper gemäß einem der vorhergehenden Ansprüche, wobei die Verbindungsschicht einen Durchbruch (4) und die
Leiterschicht einen gedünnten Bereich aufweist und der Durchbruchlateral mit dem gedünnten Bereich der Leiterschicht überlappt.

8. Trägerkörper gemäß einem der vorhergehenden Ansprüche, wobei die Verbindungsschicht einen Durchbruch (4) und einen an
den Durchbruch angrenzenden Teil aufweist, der einen Teil der Leiterschicht lateral überragt, wobei ein Bereich zwischen diesen Teilen frei von Material des Trägerkörpers ist.

9. Trägerkörper gemäß einem der vorhergehenden Ansprüche, wobei an einem Rand ein Teil der Verbindungsschicht vorhanden ist, der einen Teil der Leiterschicht lateral überragt, und ein Bereich zwischen diesen Teilen frei von Material des Trägerkörpers ist.

10. Trägerkörper gemäß einem der vorhergehenden Ansprüche, wobei ein Chipmontagebereich (5)
auf einem Teil der Leiterschicht vorgesehen ist und die Verbindungsschicht der Leiterschicht auf der Seite des Chipmontagebereiches nachgeordnet ist, und insbesondere mindestens eine Innenwand vorhanden ist, deren Haupterstreckungsebene schräg zu einer Haupterstreckungsebene des Trägerkörpers oder der Leiterschicht elektrischen Anschlussleiters verläuft und verglichen mit dieser Haupterstreckungsebene zu dem Chipmontagebereich hin gekippt ist.

11. Trägerkörper nach einem der vorhergehenden Ansprüche, wobei die Leiterschicht und die Verbindungsschicht mittels eines Verbindungsmittels (3) miteinander verbunden sind.

12. Halbleiterbauelement mit einem Trägerkörper gemäß einem der vorhergehenden Ansprüche,
wobei die Leiterschicht auf einer ersten Seite mit einem Halbleiterchip (50) und mit der Kapselmasse versehen ist, die Kapselmasse den Halbleiterchip umschließt und an den Trägerkörper angeformt ist.

13. Halbleiterbauelement nach Anspruch 12,
wobei die Leiterschicht auf einer der ersten Seite gegenüberliegenden zweiten Seite in einem lateral mit der Kapselmasse und/oder mit der Kapselmasse und dem Halbleiterchip überlappenden Bereich frei von der Kapselmasse und von elektrisch isolierendem Material ist.

14. Verfahren zum Herstellen eines Trägerkörpers, mit den
Schritten:
Bereitstellen einer Leiterschicht (12) und einer Verbindungsschicht (11) , die jeweils zwei voneinander abgewandte Hauptflächen aufweisen;
Verbinden der Leiterschicht mit der Verbindungsschicht über zwei ihrer Hauptflächen, derart, dass diese Hauptflächen einander zugewandt sind, wobei die Verbindungsschicht elektrisch leitfähig ist und gegenüber der Leiterschicht elektrisch isoliert ist oder die Verbindungsschicht elektrisch isolierend ist;
Ausbilden mindestens eines gedünnten Bereichs (111, 112, 113, 114, 115, 116, 121, 122, 123, 124, 125) in der Leiterschicht und der Verbindungsschicht, in dem die Schichtdicke (14,24) der entsprechenden Schicht geringer als ihre maximale Schichtdicke (13, 23) ist, wobei sowohl der Trägerkörper als auch die Leiterschicht und die Verbindungsschicht für sich selbsttragende Elemente sind und wobei der gedünnte Bereich (121, 122, 123, 124, 125) der Leiterschicht lateral mit dem gedünnten Bereich (111, 112, 113, 114, 115, 116) der Verbindungsschicht überlappt;
Anformen einer Kapselmasse (9) an eine erste Seite des Trägerkörpers, wobei die Kapselmasse an die Leiterschicht und die Verbindungsschicht angeformt wird und ein Silikon aufweist, und wobei eine Lücke zwischen den überlappenden gedünnten Bereichen der Leiterschicht und der Verbindungsschicht vorhanden ist, die von der Kapselmasse ausgefüllt wird.

## Claims

1. Carrier body (10) for a semiconductor component, comprising an electrically conductive conductor layer (12) and a connecting layer (11), which are connected to one another via main areas facing one another,
wherein the connecting layer (11) is completely electrically conductive and is electrically insulated at least from parts of the conductor layer (12)
or the connecting layer (11) is electrically insulating at least in parts,
wherein the conductor layer (12) and the connecting layer (11) each have at least one thinned region (111, 112, 113, 114, 115, 116, 121, 122, 123, 124, 125) in which their layer thickness (14, 24) is less than their maximum layer thickness (13, 23),
wherein the carrier body (10) as well as the conductor layer (12) and the connecting layer (11) per se are self-supporting elements, wherein the carrier body has a first side, at which an encapsulating composition (9) is integrally formed onto the conductor layer (12) and the connecting layer (11), said encapsulating composition comprising a silicone,
wherein the thinned region (121, 122, 123, 124, 125) of the conductor layer laterally overlaps the thinned region (111, 112, 113, 114, 115, 116) of the connecting layer and
wherein a gap is present between the overlapping thinned regions of the conductor layer and the connecting layer, said gap being filled by the encapsulating composition (9).

2. Carrier body according to Claim 1,
wherein the silicone has a degree of hardness in the range of Shore A = 20 to D = 90 with a refractive index of 1.41 to 1.57.

3. Carrier body according to Claim 1 or 2,
having a second side, lying opposite the first side,
wherein the conductor layer (12), at the second side, is at least partly free of the encapsulating composition and of electrically insulating material in those regions in which, at the first side, encapsulating composition is integrally formed onto the conductor layer.

4. Carrier body according to any of the preceding claims,
wherein the conductor layer (12) has at least two parts (21, 22) which are electrically insulated from one another, which form a first and a second electrical connection conductor for a semiconductor component and which are mechanically connected to one another by means of at least one part of the connecting layer (11).

5. Carrier body according to any of the preceding claims,
wherein the conductor layer is part of a first leadframe, the connecting layer is part of a second leadframe and the two leadframes are connected to one another in an electrically insulating fashion.

6. Carrier body according to any of the preceding claims,
wherein the connecting layer and/or the conductor layer have/has a perforation (4) and a thinned region adjoining the perforation.

7. Carrier body according to any of the preceding claims,
wherein the connecting layer has a perforation (4) and the conductor layer has a thinned region and the perforation laterally overlaps the thinned region of the conductor layer.

8. Carrier body according to any of the preceding claims,
wherein the conductor layer has a perforation (4) and a part which adjoins the perforation and which laterally projects above a part of the conductor layer, wherein a region between these parts is free of material of the carrier body.

9. Carrier body according to any of the preceding claims,
wherein, at an edge, a part of the connecting layer is present which laterally projects above a part of the conductor layer, and a region between these parts is free of material of the carrier body.

10. Carrier body according to any of the preceding claims,
wherein a chip mounting region (5) is provided on a part of the conductor layer and the connecting layer is displaced downstream of the conductor layer on the side of the chip mounting region, and, in particular, at least one inner wall is present, the main extension plane of which runs obliquely with respect to a main extension plane of the carrier body or of the conductor layer of the electrical connection conductor and is tilted toward the chip mounting region compared with said main extension plane.

11. Carrier body according to any of the preceding claims,
wherein the conductor layer and the connecting layer are connected to one another by means of a connecting means (3).

12. Semiconductor component comprising a carrier body according to any of the preceding claims,
wherein the conductor layer is provided with a semiconductor chip (50) and with the encapsulating composition on a first side, and the encapsulating composition encloses the semiconductor chip and is integrally formed onto the carrier body.

13. Semiconductor component according to Claim 12,
wherein the conductor layer, on a second side lying opposite the first side, is free of the encapsulating composition and of electrically insulating material in a region laterally overlapping the encapsulating composition and/or the encapsulating composition and the semiconductor chip.

14. Method for producing a carrier body, comprising the following steps:
providing a conductor layer (12) and a connecting layer (11), which in each case have two main areas facing away from one another;
connecting the conductor layer to the connecting layer via two of their main areas in such a way that said main areas face one another, wherein the connecting layer is electrically conductive and is electrically insulated from the conductor layer or the connecting layer is electrically insulating;
forming at least one thinned region (111, 112, 113, 114, 115, 116, 121, 122, 123, 124, 125) in the conductor layer and the connecting layer, in which region the layer thickness (14, 24) of the corresponding layer is less than the maximum layer thickness (13, 23) thereof, wherein both the carrier body and
the conductor layer and the connecting layer per se are self-supporting elements and wherein the thinned region (121, 122, 123, 124, 125) of the conductor layer laterally overlaps the thinned region (111, 112, 113, 114, 115, 116) of the connecting layer;
integrally forming an encapsulating composition (9) at a first side of the carrier body, wherein the encapsulating composition is integrally formed onto the conductor layer and the connecting layer and comprises a silicone, and wherein a gap is present between the overlapping thinned regions of the conductor layer and the connecting layer, said gap being filled by the encapsulating composition.

## Revendications

1. Corps de support (10) pour un composant semi-conducteur, avec une couche de conducteur électroconductrice (12) et une couche de liaison (11), lesquelles sont reliées ensemble par l'intermédiaire de surfaces principales tournées l'une vers l'autre,
dans lequel la couche de liaison (11) est complètement électroconductrice et est isolée électriquement au moins par rapport à des parties de la couche de conducteur (12) ou bien la couche de liaison (11) est électriquement isolante au moins dans des parties,
dans lequel la couche de conducteur (12) et la couche de liaison (11) présentent respectivement au moins une zone amincie (111, 112, 113, 114, 115, 116, 121, 122, 123, 124, 125) dans laquelle leur épaisseur de couche (14, 24) est inférieure à leur épaisseur de couche maximale (13, 23),
dans lequel le corps de support (10) tout comme également la couche de conducteur (12) et la couche de liaison (11) sont des éléments autoporteurs en soi,
dans lequel le corps de support présente un premier côté sur lequel une masse d'encapsulage (9) est formée sur la couche de conducteur (12) et la couche de liaison (11), laquelle présente un silicone,
dans lequel la zone amincie (121, 122, 123, 124, 125) de la couche de conducteur est en superposition latérale avec la zone amincie (111, 112, 113, 114, 115, 116) de la couche de liaison et
dans lequel il y a un interstice entre les zones amincies se superposant de la couche de conducteur et de la couche de liaison, lequel est rempli par la masse d'encapsulage (9).

2. Corps de support selon la revendication 1,
dans lequel le silicone présente un degré de dureté dans la plage de Shore A = 20 à D = 90 avec un indice de réfraction de 1,41 à 1,57.

3. Corps de support selon la revendication 1 ou 2, présentant une deuxième côté qui est situé en vis-à-vis du premier côté,
dans lequel la couche de conducteur (12) est au moins partiellement libre de la masse d'encapsulage et du matériau électriquement isolant sur le deuxième côté dans celles des zones dans lesquelles de la masse d'encapsulage est formée sur la couche de conducteur sur le premier côté.

4. Corps de support selon l'une des revendications précédentes,
dans lequel la couche de conducteur (12) présente au moins deux parties (21, 22) isolées électriquement l'une de l'autre, lesquelles forment un premier et un deuxième conducteur de connexion électrique pour un composant semi-conducteur et lesquelles sont reliées mécaniquement ensemble au moyen d'au moins une partie de la couche de liaison (11).

5. Corps de support selon l'une des revendications précédentes, dans lequel la couche de conducteur est une partie d'un premier conducteur poutre, la couche de liaison étant une partie d'un deuxième conducteur poutre et les deux conducteurs poutre étant reliés ensemble de manière électriquement isolante.

6. Corps de support selon l'une des revendications précédentes,
dans lequel la couche de liaison et/ou la couche de conducteur présentent une brèche (4) et une zone amincie qui est adjacente à la brèche.

7. Corps de support selon l'une des revendications précédentes,
dans lequel la couche de liaison présente une brèche (4) et la couche de conducteur une zone amincie, et la brèche étant en superposition latérale avec la zone amincie de la couche de conducteur.

8. Corps de support selon l'une des revendications précédentes,
dans lequel la couche de liaison présente une brèche (4) et une partie adjacente à la brèche qui surplombe latéralement une partie de la couche de conducteur, dans lequel une zone entre ces parties est libre de matériau du corps de support.

9. Corps de support selon l'une des revendications précédentes,
dans lequel une partie de la couche de liaison est présente sur un bord, laquelle partie surplombe latéralement une partie de la couche de conducteur, et une zone entre ces parties étant libre de matériau du corps de support.

10. Corps de support selon l'une des revendications précédentes,
dans lequel on prévoit une zone de montage de puce (5) sur une partie de la couche de conducteur, et la couche de liaison de la couche de conducteur étant disposée en aval sur le côté de la zone de montage de puce, et en particulier au moins une paroi interne étant présente, dont le plan d'extension principal s'étend en biais par rapport à un plan d'extension principal du corps de support ou de la couche de conducteur de la connexion électrique et est incliné vers la zone de montage de puce en comparaison avec ce plan d'extension principal.

11. Corps de support selon l'une des revendications précédentes,
dans lequel la couche de conducteur et la couche de liaison sont reliées ensemble au moyen d'un moyen de liaison (3).

12. Composant semi-conducteur avec un corps de support selon l'une des revendications précédentes,
dans lequel la couche de conducteur est munie sur un premier côté d'une puce semi-conductrice (50) et de la masse d'encapsulage, la masse d'encapsulage entourant la puce semi-conductrice et étant formée sur le corps de support.

13. Composant semi-conducteur selon la revendication 12,
dans lequel, sur un deuxième côté situé en vis-à-vis du premier côté, dans une zone en superposition latérale avec la masse d'encapsulage et/ou avec la masse d'encapsulage et la puce semi-conductrice, la couche de conducteur est libre de la masse d'encapsulage et du matériau électriquement isolant.

14. Procédé pour la fabrication d'un corps de support, avec les étapes suivantes :
la mise à disposition d'une couche de conducteur (12) et
d'une couche de liaison (11) qui présentent respectivement deux surfaces principales se tournant le dos ;
la liaison entre la couche de conducteur et la couche de liaison par l'intermédiaire de deux de leurs surfaces principales d'une manière telle que ces surfaces principales sont tournées l'une vers l'autre, dans lequel la couche de liaison est électroconductrice et est isolée électriquement par rapport à la couche de conducteur ou bien la couche de liaison étant électriquement isolante ;
la formation d'au moins une zone amincie (111, 112, 113, 114, 115, 116, 121, 122, 123, 124, 125) dans la couche de conducteur et la couche de liaison, dans laquelle l'épaisseur de couche (14, 24) de la couche correspondante est inférieure à son épaisseur de couche maximale (13, 23),
dans lequel le corps de support tout comme également la couche de conducteur et la couche de liaison sont des éléments autoporteurs en soi, et dans lequel la zone amincie (121, 122, 123, 124, 125) de la couche de conducteur est en superposition latérale avec la zone amincie (111, 112, 113, 114, 115, 116) de la couche de liaison ;
la formation d'une masse d'encapsulage (9) sur un premier côté du corps de support, dans lequel la masse d'encapsulage est formée sur la couche de conducteur et la couche de liaison et présente un silicone, et dans lequel un interstice existe entre les zones amincies se superposant de la couche de conducteur et de la couche de liaison, lequel est rempli par la masse d'encapsulage.
